# EUROPEAN PATENT APPLICATION

(11) **EP 2 916 335 A1**
(43) Date of publication of application: **09.09.2015**
(21) Application number: 12887637.2
(22) Date of filing: 30.10.2012
(51) Int. Cl.: H01F 41/04, H01F 17/00

(54) **COIL ELEMENT PRODUCTION METHOD**

(71) Applicant: Leap Co. Ltd., Kanagawa 224-0032 (JP)
(72) Inventor: SANO, Takashi, Yokohama-shi Kanagawa 224-0032 (JP); TERADA, Tokinori, Yokohama-shi Kanagawa 224-0032 (JP)
(74) Representative: Becker Kurig Straus
(86) International application number: PCT/JP2012/006961
(87) International publication number: WO 2014/068613

(57) **Abstract**

Provided is a method for manufacturing a coil element, which does not adversely affect the coil element pattern after taking out for use. A method for manufacturing a coil element using a transferring mold, includes: preparing a transferring mold, on a surface of which an inverted coil element pattern is engraved, the transferring mold having at least a surface part made of metal; forming a center conductive film by first electroplating at the transferring mold as a whole so as to have a thickness exceeding a thickness of an area where the inverted coil element pattern is engraved; removing the center conductive film from a surface by a predetermined thickness by polishing or grinding so as to flatten the surface of the center conductive film; releasing the flattened center conductive film from the transferring mold; coating a protective film at a surface as a whole of the released center conductive film on a side where the coil element pattern is formed; etching the center conductive film for removal from the side subjected to the flattening so that the side reaches the protective film; and removing the protective film and taking out the center conductive film.

## Description

### Technical Field

The present invention relates to methods for manufacturing coil elements, and particularly relates to a method for manufacturing a coil element, capable of making coil elements uniform in height, the coil elements being prepared by releasing and transferring using a mold for transferring.

### Background Art

With the recent development of mobile devices such as smartphones and table terminals equipped with multifunctions, there is a growing need for coil components (inductors) that are compact in size and capable of operating with high rated current.

A known method for manufacturing such a coil component is to use a mold for transferring. Patent Document 1 describes a method for manufacturing an electronic component by electroforming (this may be called electroplating). In this method, a mother mold is manufactured firstly from a master mold, and next, a sun mold for transferring is manufactured by nickel electroforming on a surface of the mother mold. Then, this sun mold for transferring is released from the mother mold, and a component is manufactured by using this sun mold as a work mold.

### Citation List

### Patent Document

Patent Document 1: JP 2008-049614 A

### Summary of the Invention

### Problems to be solved by the Invention

Some coil elements have to be manufactured using a mold for transferring so as to make a coil pattern at a leading electrode part of the coil element have a height (H) higher than other part so as to be connected to a coil element at an upper layer for multi-layer connection. In that case, the pattern of the coil element that is engraved in the mold for transferring has to be made deeper partly at the leading electrode part.

When metal such as copper (Cu) is electrodeposited by electroforming at such a coil element pattern having different depths, the metal electrodeposited will have unevenness in accordance with such depths, which adversely affects the transferring of the coil element pattern.

In order to solve the problem, the present invention aims to provide a method for manufacturing a coil element by removing a conductive film after electroforming by a predetermined thickness from the surface by polishing or grinding so as to eliminate the unevenness at the surface of the conductive film, so as to manufacture a coil element which does not adversely affect the coil element pattern after taking out for use.

### Means for solving the Problems

Means of the present invention relates to a method for manufacturing a coil element using a transferring mold, and the method includes: preparing a transferring mold, on a surface of which an inverted coil element pattern is engraved, the transferring mold having at least a surface part made of metal; forming a center conductive film by first electroplating at the transferring mold as a whole so as to have a thickness exceeding a thickness of an area where the inverted coil element pattern is engraved; removing the center conductive film from a surface by a predetermined thickness by polishing or grinding so as to flatten the surface of the center conductive film; releasing the flattened center conductive film from the transferring mold; coating a protective film at a surface as a whole of the released center conductive film on a side where the coil element pattern is formed; etching the center conductive film for removal from the side subjected to the flattening so that the side reaches the protective film; and removing the protective film and taking out the center conductive film.

The means of the present invention further includes forming a surface conductive film by second electroplating while using the taken-out center conductive film as a base, thus forming a coil element including the center conductive film and the surface conductive film. The surface part of the transferring mold includes Ni, and on a surface of Ni, NiO is formed.

In the means of the present invention, the protective film includes SiO₂, SOG or resist.

The protective film is formed by a CVD or sputtering.

The etching of the center conductive film is performed using ferric chloride solution.

### Advantageous Effect of the Invention

According to the present invention, a coil element pattern having different thicknesses can be formed from a flattened face, which has the advantageous effect of facilitating the manufacturing of a coil component connected via multi-layers.

### Brief Description of the Drawings

FIG. 1 illustrates steps of manufacturing a coil element according to the present invention.
FIG. 2 is a plan view of a coil element assembly manufactured using a transferring mold substrate.
FIG. 3 illustrates the state of lamination of a plurality of coil element assemblies.
FIG. 4 describes the lamination of a plurality of coil element assemblies and connecting the coil elements at the respective layers to form a coil.
FIG. 5 illustrates the state where a coil is hermetically sealed using an upper core and a lower core.
FIG. 6 illustrates the state where a coil is internally filled with an insulating substance.
FIG. 7 illustrates dicing of the laminated coil element assemblies in the units of coils.
FIG. 8 illustrates the step of attaching an external electrode at a leading electrode part to form a coil component.

### Mode for carrying out the Invention

The following describes the present invention in details, with reference to the attached drawings.

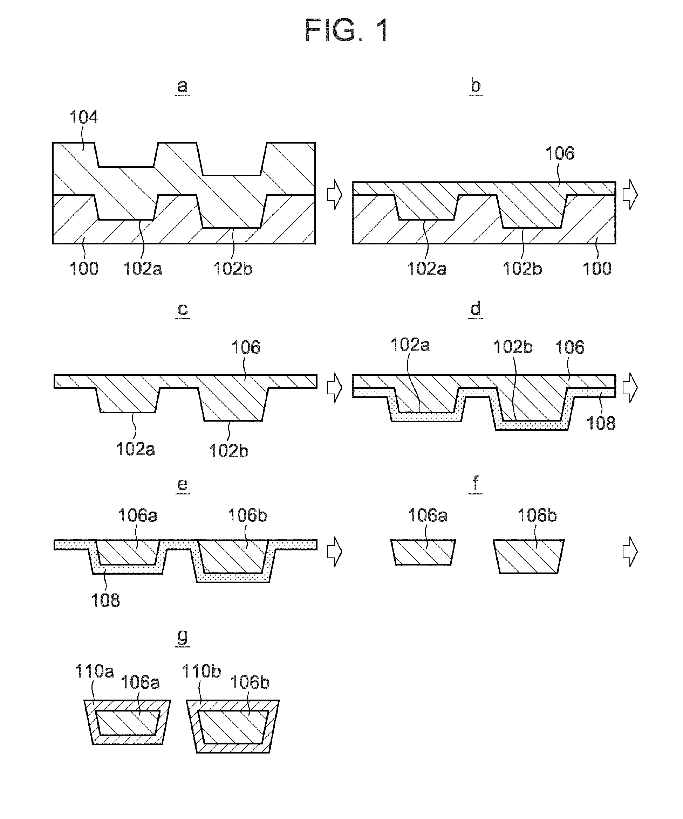

FIG. 1 illustrates steps of manufacturing a coil element according to the present invention.

Firstly as illustrated in FIG. 1a, a metal transferring mold 100 made of nickel (Ni) or the like is prepared, having a surface in which an inverted coil element pattern 102a and 102b is engraved. The metal transferring mold 100 may be made of metal at least at a surface part, and is not necessarily made of metal as a whole. When the surface part of the transfer mold 100 is made of Ni, the surface may be oxidized to form NiO, which facilitates the releasing of a center conductive film at a later step. The inverted coil element pattern 102a and 102b may have parts of different depths.

Next, a center conductive film 104 is formed by electroplating of copper (Cu), for example, at the entire face of the transferring mold 100 so as to have a thickness exceeding the thickness of the area where the inverted coil element pattern 102a and 102b is engraved. At this time, the surface of the center conductive film 104 has unevenness that reflects the depths of the inverted coil element pattern 102a and 102b as it is.

Then as illustrated in FIG. 1b, the center conductive film 104 is removed by polishing or grinding by a predetermined thickness from the surface so as to remove the unevenness at the surface to be flat. This can form a center conductive film 106 whose surface is flat. Next as illustrated in FIG. 1c, the center conductive film 106 having the flat surface is released from the transferring mold 100.

Then, as illustrated in FIG. 1d, a protective film 108 is coated at the entire surface of the thus released center conductive film 106 on which the inverted coil element pattern 102a and 102b is formed.

The protective film 108 used may be made of SiO₂, SOG or resist, which may be formed by a CVD or sputtering.

Next as illustrated in FIG. 1e, etching is performed from the flattened side of the center conductive film 106 until the center conductive film is removed to reach the protective film 108. This etching of the center conductive film 106 may be performed using ferric chloride solution. Next as illustrated in FIG. 1f, the protective film 108 is removed, and the center conductive film 106a, 106b is taken out.

In this way, the center conductive film 106a, 106b taken out can be used as coil elements having different thicknesses. When a high-density coil element is manufactured by narrowing the interval of the center conductive film 106a, 106b, surface conductive film 110a, 110b may be formed by electroplating while using the center conductive film 106a, 106b as a base as illustrated in FIG. 1g, so as to make the center conductive film 106a, 106b thick.

In the above description, one coil element is manufactured considering one transferring mold. When a coil element assembly having a plurality of coil elements is collectively manufactured, a transferring mold substrate including a plurality of transferring molds, each of which has an inverted coil element pattern engraved therein may be used for manufacturing in a similar manner.

Next, the following describes a method for manufacturing a coil component using the thus manufactured coil element assembly. As described later, a coil component is manufactured by laminating a plurality of coil element assemblies.

Then in order to connect coil elements at the respective layers for bonding, a bonding film has to be formed beforehand around the coil elements.

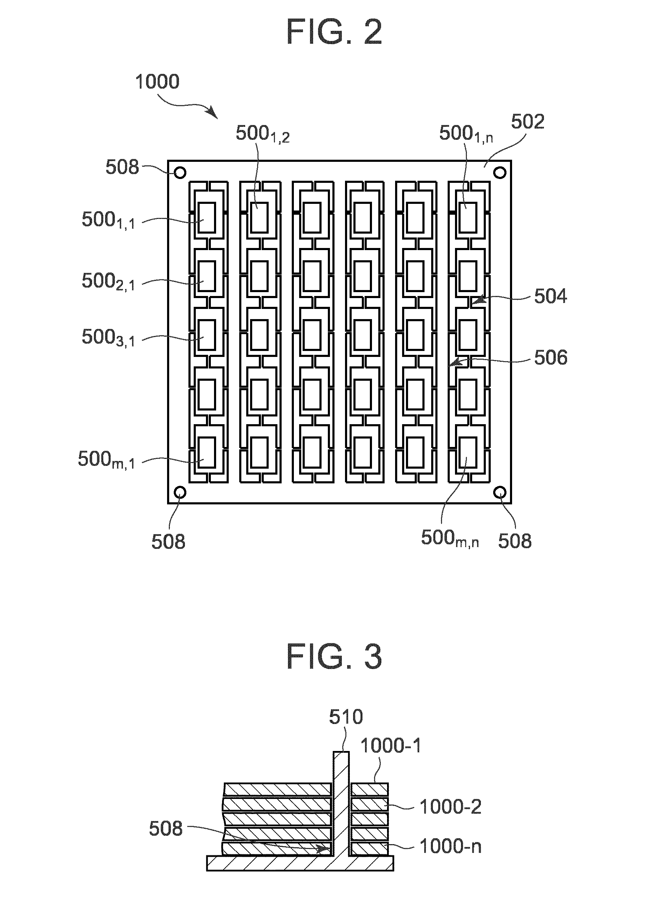

FIG. 2 is a plan view of a coil element assembly 1000 manufactured using a transferring mold substrate. A transferring mold substrate to manufacture this coil element assembly 1000 also has the same shape. In order to reinforce the conductive pattern of a plurality of coil elements 500m,n (m, n=1, 2, ...), a rib 502, a gate 504, and a runner 506 are provided. At four corners of the rib 502, holes 508 are bored, and using a pin 510 penetrating through this hole 508, positioning of conductive patterns of the coil elements 500m,n formed at the respective layers of the plurality of coil element assemblies 1000 is performed.

As illustrated in FIG. 3, a plurality of coil element assemblies 1000-1, 1000-2, ... 1000-N are laminated via the pin 510 so that their corresponding coil elements in the coil element assemblies are matched, followed by heating and/or pressurizing for bonding, thus connecting the coil elements at the layers to form a coil. The heating and/or pressurizing melts tin plating of the joint film, which acts as soldering to bond the coil elements at the respective layers.

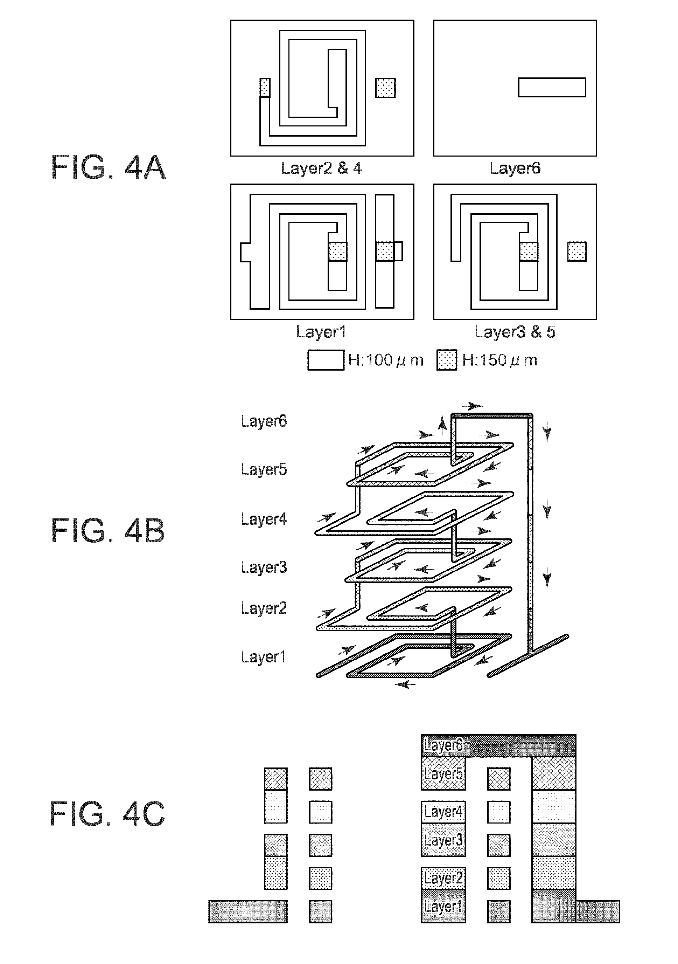

FIG. 4 describes the lamination of a plurality of coil element assemblies and connecting the coil elements at the respective layers to form a coil. In the embodiment illustrated in FIG. 4, six layers of coil element assemblies are laminated, and coil elements at the respective layers are connected so as to form one coil. The corresponding coil elements in the plurality of coil element assemblies may have mutually different coil patterns.

In the example of FIG. 4, a first layer (Layer 1), a third layer (Layer 3) and a sixth layer (Layer 6) have mutually different coil patterns, and a second layer (Layer 2) and a fourth layer (Layer 4) have the same coil pattern and the third layer (Layer 3) and a fifth layer (Layer 5) have the same coil pattern. (B) and (C) illustrate the state of the lamination of these six layers of coil element assemblies, bonding of the corresponding coil elements at the respective layers while being matched and connecting the coil elements to form one coil.

In the manufacturing of a coil element of the present invention, as illustrated in FIG. 4(A), the center conductive layers making up the coil elements have different heights (H) at the connecting part of each layer. In the example of (A), the height (H) at the pattern of a typical coil element is 100 µm, and the height (H) is 150 µm at the connecting part between layers.

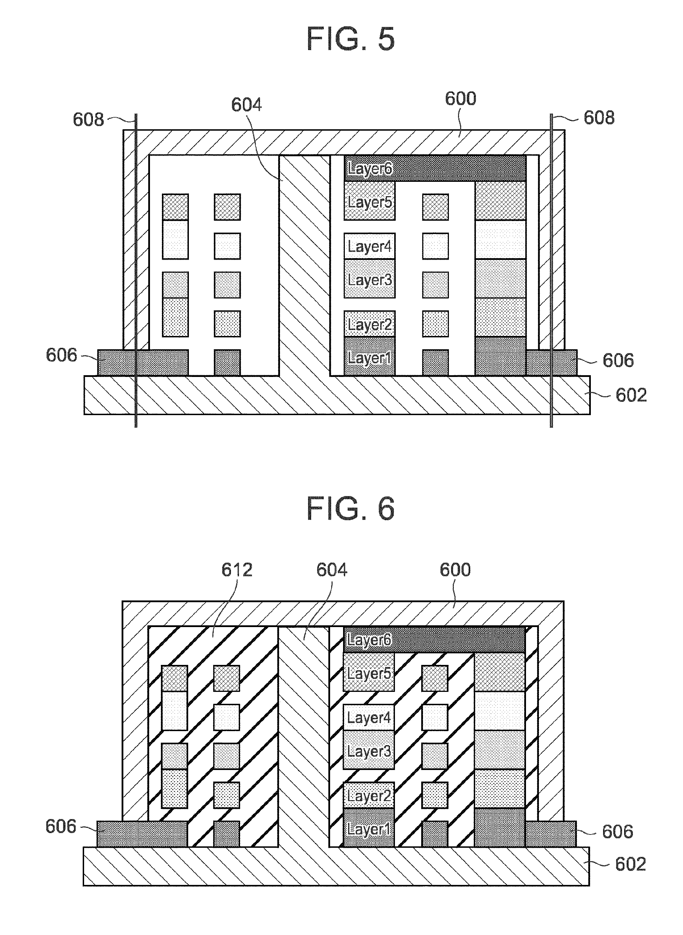

In this way, a coil is formed by connecting the coil elements at the respective layers, then as illustrated in FIG. 5, an upper core 600 and a lower core 602 made of magnetic body, one of which has a protrusion 604 to penetrate through the center part of the coil, are used for hermetically-sealing of the coil while exposing a leading electrode part 606 to the outside. At this time, the upper core 600 and the lower core 602 are attached to circumvent the gate 504 illustrated in FIG. 2 for pattern reinforcement. The upper core 600 and the lower core 602 are cut along a dicing line 608 at the later dicing step. Next, as illustrated in FIG. 6, an insulating substance 612 is poured through a gap (not illustrated) between the upper core 600 and the lower core 602 to fix the coil.

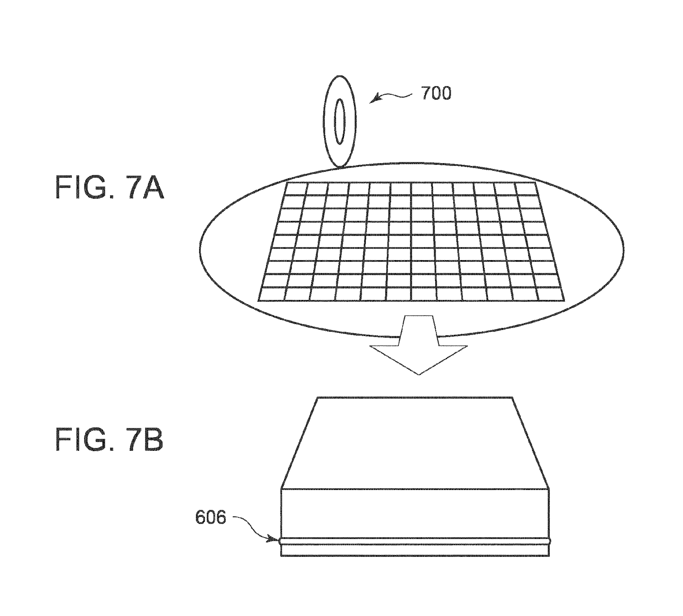

Next, as illustrated in FIG. 7, the laminated coil element assemblies are cut in the units of coils using a cutter 700. (A) illustrates a coil element assembly, and (B) illustrates one coil component, where the leading electrode part 606 is formed as a part of the first layer (Layer 1).

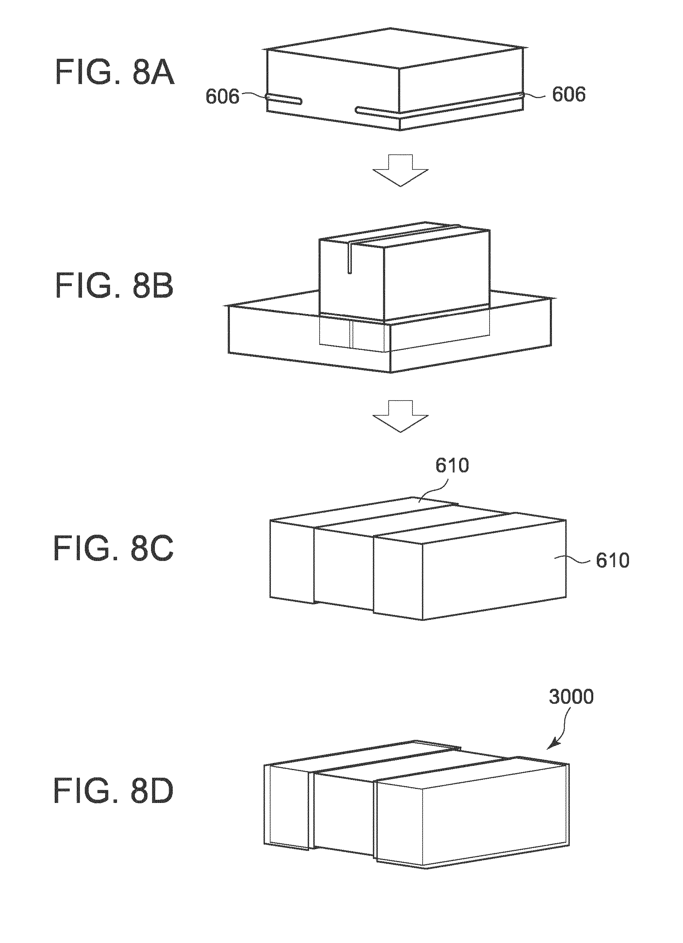

Finally as illustrated in FIG. 8, an external electrode 610 is attached to the leading electrode part 606 by dip soldering or the like, to which soldering is performed as pretreatment for subsequent soldering, thus finishing a coil component 3000.

### Description of Reference Numerals

- 100: transferring mold
- 102a, 102b: inverted coil element pattern
- 104: center conductive film
- 106: released center conductive film
- 108: protective film
- 110a, 110b: surface conductive film

## Claims

1. A method for manufacturing a coil element using a transferring mold, comprising:
preparing a transferring mold, on a surface of which an inverted coil element pattern is engraved, the transferring mold having at least a surface part made of metal;
forming a center conductive film by first electroplating at the transferring mold as a whole so as to have a thickness exceeding a thickness of an area where the inverted coil element pattern is engraved;
removing the center conductive film from a surface by a predetermined thickness by polishing or grinding so as to flatten the surface of the center conductive film;
releasing the flattened center conductive film from the transferring mold;
coating a protective film at a surface as a whole of the released center conductive film on a side where the coil element pattern is formed;
etching the center conductive film for removal from the side subjected to the flattening so that the side reaches the protective film; and
removing the protective film and taking out the center conductive film.

2. The method according to claim 1, further comprising forming a surface conductive film to cover the center conductive film by second electroplating while using the taken-out center conductive film as a base, thus forming a coil element including the center conductive film and the surface conductive film.

3. The method according to claim 1, wherein the surface part of the transferring mold includes Ni, and on a surface of Ni, NiO is formed.

4. The method according to claim 1, wherein the protective film includes SiO₂, SOG or resist.

5. The method according to claim 1, wherein the protective film is formed by a CVD or sputtering.

6. The method according to claim 1, wherein the etching of the center conductive film is performed using ferric chloride solution.
